# EUROPEAN PATENT APPLICATION

(11) **EP 1 455 384 A2**
(43) Date of publication of application: **08.09.2004**
(21) Application number: 04076537.2
(22) Date of filing: 10.09.1997
(51) Int. Cl.: H01L 21/00

(54) **An apparatus for fabricating a semiconductor device and a method for fabricating a polysilicon film using the same**

(62) Divisional of application: 97307010.5
(71) Applicant: Samsung Electronics Co., Ltd., Suwon-si, Gyeonggi-do 442-742 (KR)
(72) Inventor: Park, Young-wook, Suwon-city Kyungki-do (KR); Yoo, Cha-young, Yongin-city Kyungki-do (KR); Kim, Young-sun, Seoul 121-021 (KR); Nam, Seung-hee, Seoul (KR)
(74) Representative: Kyle, Diana

(57) **Abstract**

An apparatus for fabricating a semiconductor device having cooling jackets for preventing a gas being exuded in a reaction chamber and minimizing the generation of contaminant particles includes a reaction chamber (220) having first to fourth cooling jackets (400,410,420,430) mounted on a first side wall (300) adjacent to a wafer transfer chamber (210), a second side wall (320) opposite to the first side wall (300), an upper wall (340) and a bottom wall (360), respectively. A gate valve (310) is equipped between the reaction chamber (220) and the wafer transfer chamber (210) with a fifth cooling jacket (440). The method, the pressure of a cassette chamber (200) is controlled to be less than 0.05mtorr or the pressure of a cooling chamber (230) and the wafer transfer chamber (210) are controlled to be less than 1.0µtorr by controlling pumping down time.

## Description

To manufacture a reliable semiconductor device, it is required to keep the temperature of the apparatus for fabricating the semiconductor device uniform and to minimize the contaminant particles.

Especially, in the case of forming a lower electrode with a hemispherical silicon grain (which is referred to as HSG-Si) to enlarge the electrostatic capacitance of a capacitor in terms of increasing the area of the lower electrode, it is critical to keep the temperature of the reaction chamber uniform and to keep the inside of the reaction chamber clean.

Typically, to form the lower electrode with the HSG-Si, a crystal growing step for forming crystal grains by migrating the amorphous silicon to the nucleus of crystalline silicon need to be stable and a speed of silicon surface migration for the growth of the crystal grain need to be faster than the speed of the amorphous silicon crystallization in lower amorphous silicon. For the amorphous silicon to move toward the nucleus of the crystalline silicon, the amorphous silicon should have a free surface on which the silicon atoms of the surface are not combined to any other atoms. Namely, when the surface is contaminated with other materials, the surface movement of the amorphous silicon atoms gets hard since the amorphous silicon atoms are combined to the atoms of the other materials, thus making any further generation and growth of nucleus impossible. Therefore, to remove the contaminants of the wafer surface transferred to the reaction chamber and to keep the inside of the chamber clean are important factors in a processing.

In a general apparatus for fabricating the semiconductor device, a cassette chamber in which a carrier having a wafer is loaded, a reaction chamber in which a processing for fabricating a semiconductor device proceeds, and a wafer cooling chamber after completing the processing are respectively connected to a polyhedral transfer chamber having a robot arm for transferring the wafer to the respective chambers.

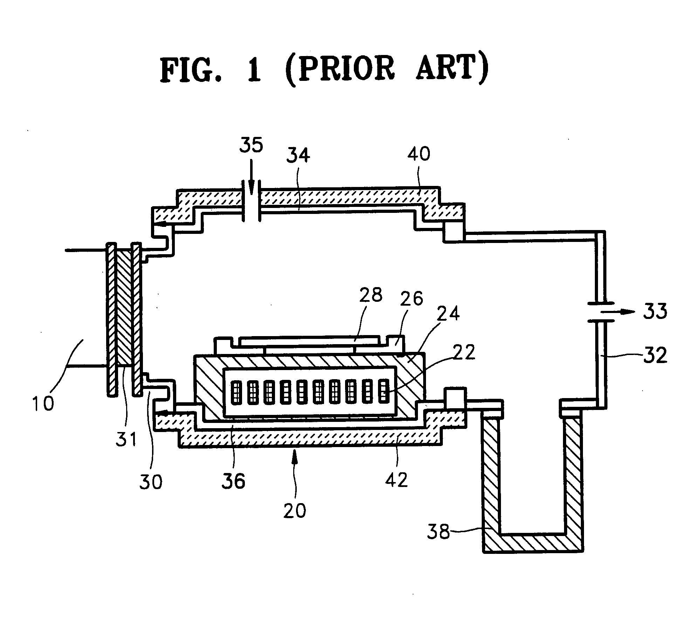

The structure of the reaction chamber in which the processing for fabricating the device proceeds is described as follows with reference to FIG. 1. A gate valve 31 which separates a wafer transfer chamber 10 and a reaction chamber 20 is equipped between the first side wall 30 of the reaction chamber and the wafer transfer chamber 10, and a gas vent opening 33 is formed on a second side wall 32 opposite to the first side wall 30. A gas inject opening 35 is formed to pass through an upper wall 34 of the reaction chamber and a cooling jacket 40 installed on it. A cooling jacket 42 is installed outside of a bottom wall 36 of the reaction chamber. A heating block 24 having a heater 22 and a susceptor 26 for sustaining a wafer 28 on the heating block 24 are installed inside of the reaction chamber 20. Also, a turbo pump 38 is connected to the second side wall 32 on which the gas vent opening 33 is formed.

In the case of proceeding the processing using the conventional semiconductor device fabricating apparatus shown in FIG. 1, the following problems occur.

First, the wafer is transferred to the reaction chamber 20 right after being transferred from the cassette chamber (not shown) to the wafer transfer chamber 10 by the robot arm. The pressure of the cassette chamber at the beginning of the transfer is about 1mtorr. Therefore, air pollution gas of about 1mtorr is transferred from the cassette chamber to the wafer transfer chamber when the wafer is transferred. Therefore, the wafer transfer chamber is contaminated with the air pollution gas though having a low pressure. As a result, the reaction chamber 20 connected to the wafer transfer chamber 10 is also contaminated with the air pollution gas. Therefore, the surface of the wafer is contaminated by the air pollution gas such as moisture and carbon compound during the process of raising the temperature of the wafer 28 in the reaction chamber 20, thus reducing the reliability of the processing. Especially, in the case of forming the lower electrode with the HSG-Si, it is impossible to increase the surface area since the speed of the surface migration of the amorphous silicon is reduced by adsorption of contaminants to the amorphous silicon.

Second, the surface of the wafer 28 is cleaned to remove an organic material or a native oxide film existing on the surface of the wafer prior to the processing in the reaction chamber 20. Therefore, a certain amount of moisture exists on the surface of the wafer 28 which is loaded in the cassette chamber (not shown) and the moisture is not completely evaporized and removed in the cassette chamber under the pressure of 1mtorr. Therefore, vapor is continuously generated when the wafer 28 is transferred from the wafer transfer chamber 10 to the reaction chamber 20. Especially in a process for forming the HSG-Si, the speed of the surface migration of the amorphous silicon is reduced by the vapor which is continuously generated. Thus, the increase of the surface area is also reduced.

Third, in the case of injecting cooling gas such as argon or helium of 1 to 100 torr to the cooling chamber (not shown), the cooling gas flows into the wafer transfer chamber 10 connected to the cooling chamber. The cooling gas which has flown into the wafer transfer chamber 10 reflows into the reaction chamber 20, thus acting as a contaminant. Namely, the speed of the surface migration of the amorphous silicon is reduced since the surface of the wafer 28 is contaminated by the cooling gas.

Fourth, as shown in FIG. 1, the reaction chamber includes the cooling jackets 40 and 42 for keeping the temperature thereof uniform on the upper and bottom walls 34 and 36 thereof. Therefore, each temperature of the gate valve 31 separating the transfer chamber 10 and the reaction chamber 20, the first side wall 30 adjacent to the gate valve 31 and the second side wall 32 opposite to the first side wall 30 reaches approximately 50°C and higher, since the above three portions have no cooling jackets. Thus, the surface contaminants existing in the chamber walls and the wafer may exude in the gas form. Therefore, a shortcoming is generated in the process implemented in the reaction chamber 20 due to the gas exuded from the gate valve 31, the first side wall 30, and the second side wall 32. Especially in the case of the processing for forming the HSG-Si, it is impossible to achieve the desired surface increase effect since the exuded gas is adsorbed to the surface of the silicon.

According to a first aspect of the present invention, a semiconductor device fabricating apparatus comprises:
a cassette chamber for loading a semiconductor wafer;
a wafer transfer chamber having a front portion connected to the cassette chamber;
a reaction chamber connected to a rear portion of the wafer transfer chamber, the reaction chamber having first to fourth cooling jackets mounted on a first side wall adjacent to the wafer transfer chamber, a second side wall opposite to the first side wall, an upper wall, and a bottom wall, respectively; and
a wafer cooling chamber connected to a side portion of the wafer transfer chamber.

According to a second aspect of the present invention, a polysilicon film is fabricated by the apparatus of the first aspect of the present invention by adjusting the pressure of the cassette chamber to be less than 0.05mtorr by adjusting pumping down time or adjusting the pressure of the cooling chamber to be less than 1.0µtorr, equal to that of the wafer transfer chamber. A polysilicon film is fabricated by cooling the wall of the reaction chamber by flowing refrigerant selected from the group consisting of cooling water, and mixture of the cooling water and ethylene glycol into the first to fifth cooling jackets of the apparatus of the first aspect.

Examples of the present invention will now be described in detail with reference to the accompanying drawings, in which:
FIG. 1 is a sectional view of a reaction chamber of a conventional semiconductor device fabricating apparatus;
FIG. 2 is a plan view of a semiconductor device fabricating apparatus according to an embodiment of the present invention;
FIG. 3 is a sectional view of the reaction chamber taken along the line III-III' of FIG. 2;
FIG. 4 is a graph showing the relation between pumping down time and cassette chamber pressure;
FIGS. 5A to 5E are scanning electron microscope photographs of the surface of a capacitor lower electrode formed by a method for fabricating a polysilicon film according to a first embodiment of the present invention and formed in the positions of the wafer shown in FIG. 5F;
FIGS. 6A and 6B are scanning electron microscope photographs of the surface of the capacitor lower electrode formed by a conventional semiconductor device fabricating apparatus, as a contrast group to the first embodiment;
FIG. 7A is a scanning electron microscope photograph of the surface of the capacitor lower electrode formed by a method for fabricating a polysilicon film according to a second embodiment of the present invention;
FIG. 7B is a scanning electron microscope photograph of the surface of the capacitor lower electrode formed by a conventional silicon film fabricating method, as a contrast group to the second embodiment;
FIG. 8 is a bar graph showing the value of the maximum capacitance of the capacitor shown in FIGS. 7A and 7B;
FIG. 9A is a scanning electron microscope photograph of the surface of the capacitor lower electrode formed by a polysilicon film fabricating method according to a third embodiment of the present invention;
FIG. 9B is a scanning electron microscope photograph of the surface of the capacitor lower electrode formed by a conventional polysilicon film fabricating method, as a contrast group to the third embodiment;
FIG 10A shows the capacitances of the respective portions of the wafer after forming the capacitor lower electrode by a polysilicon film fabricating method according to a fourth embodiment of the present invention;
FIG. 10B shows the capacitance of the capacitor lower electrode formed by the conventional polysilicon film fabricating method, as a contrast group to the fourth embodiment; and
FIG. 11 is a graph showing the reproductivity of the process in the case of forming the capacitor by the polysilicon film fabricating method according to the fourth embodiment of the present invention.

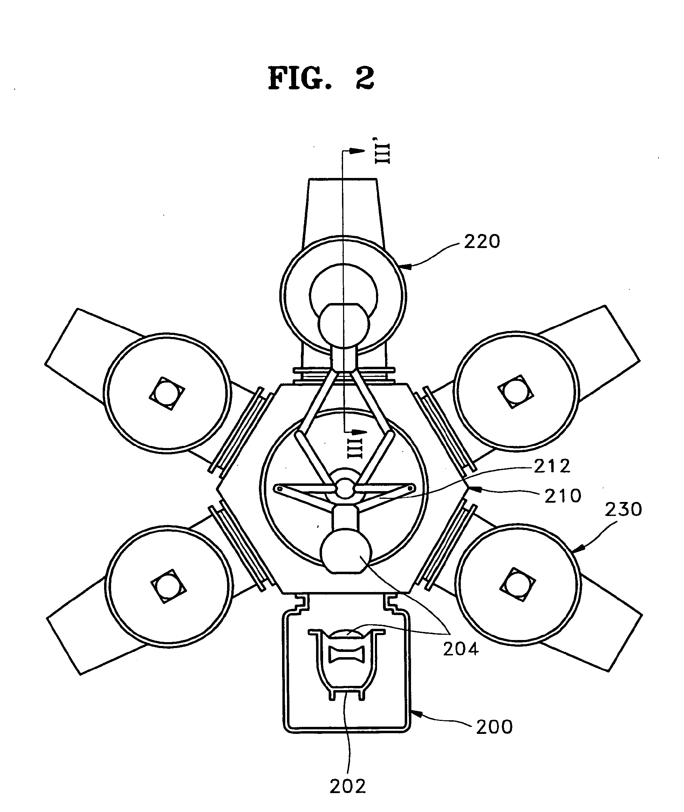

Referring to FIG. 2, the semiconductor device fabricating apparatus according to the embodiment of the present invention includes a cassette chamber 200, which a carrier 202 having a wafer 204 is loaded in and separates the carrier 202 from atmosphere, a wafer transfer chamber 210 having a robot arm 212 for transferring the wafer 204 to a reaction chamber 220, the reaction chamber 220 in which a processing for fabricating a semiconductor device proceeds, and a wafer cooling chamber 230 for cooling the wafer after completing the processing.

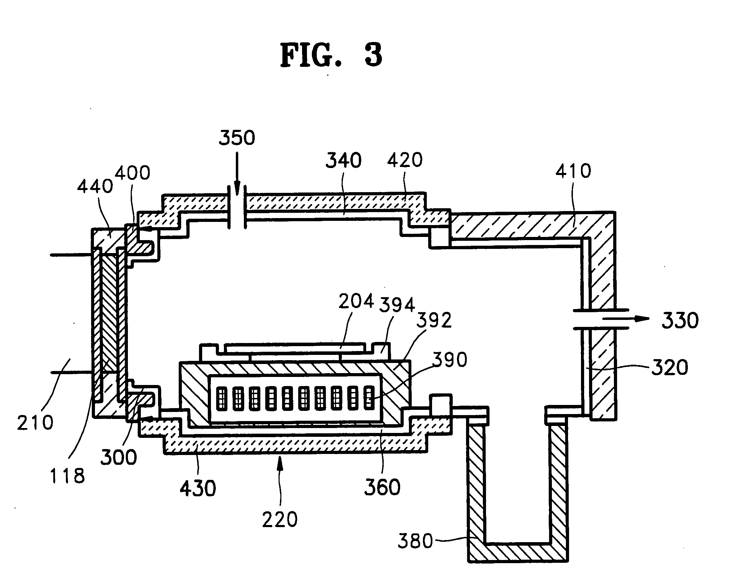

Five cooling jackets are installed in the reaction chamber 220 according to the embodiment of the present invention. They are described in detail with reference to FIG. 3 showing an amplified sectional view of the reaction chamber 220 taken along the line III-III' of FIG. 2.

Referring to FIG. 3, a gate valve 310 for separating the wafer transfer chamber 210 from the reaction chamber 220 is formed on a first side wall 300 and a first cooling jacket 400 and a second cooling jacket 410 are respectively formed on a first side wall 300 and a second side wall 320. A gas inject opening 350 is formed to pass through an upper wall of the reaction chamber 340 and a third cooling jacket 420 formed on the upper end wall of the reaction chamber 340. A fourth cooling jacket 430 is also formed outside of a bottom wall 360 of the reaction chamber. A heating block 392 having a heater 390 inside of the reaction chamber 220 and a susceptor 394 for sustain the wafer 204 on the heating block 392. A turbo pump 380 is connected to the second side wall 320 on which a gas vent opening 330 is formed and a fifth cooling jacket 440 is formed on the surface of the gate valve 310.

A refrigerant selected from the group consisting of a cooling water and a mixture of the cooling water and ethylene glycol is preferably used in the first to the fifth cooling jackets 400, 410, 420, 430, and 440. Also, it is preferable that the refrigerant substantially less than 9°C flows in the first to fifth cooling jackets, thus making the temperature in the reaction chamber 220 substantially less than 10°C.

In the semiconductor device fabricating apparatus according to the embodiment of the present invention, the cooling jackets are installed on the other walls than the upper and bottom walls of the reaction chamber. Therefore, it is possible to prevent gas from being exuded from the chamber walls by supplying the refrigerant to the respective cooling jackets during the processing in the reaction chamber.

### Method for Fabricating Polysilicon Film

### <The First Embodiment>

The first embodiment of the polysilicon film fabricating method according to the present invention is as follows. The multi-chamber type semiconductor device fabricating apparatus shown in FIG. 2 is used in the first embodiment. At this time, the reaction chamber does not have to include five cooling jackets as shown in FIG. 3 but it is sufficient to include only two cooling jackets on the upper and bottom walls like in the conventional technology.

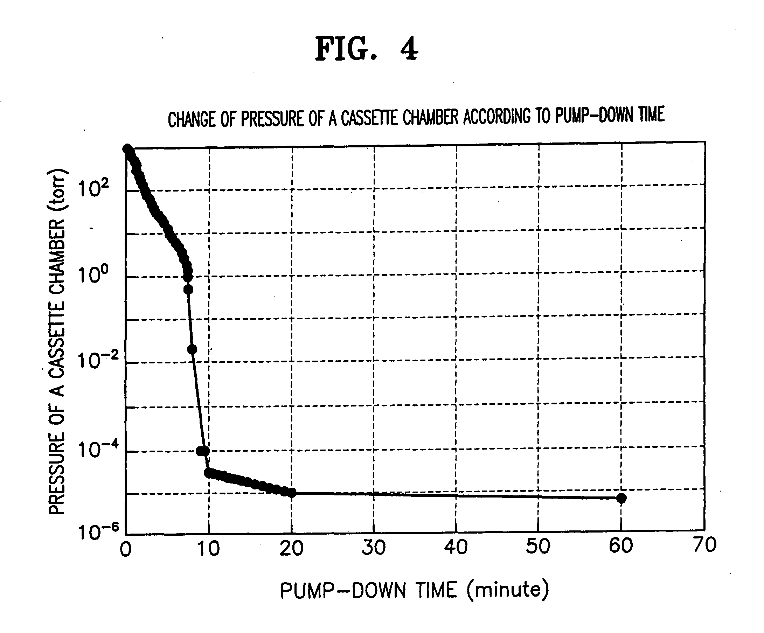

First, after loading the semiconductor wafer 204 for forming the polysilicon film in the cassette chamber 200, the pressure of the cassette chamber 200 is controlled to be less than 0.05mtorr. To control the pressure of the cassette chamber 200 to be less than 0.05mtorr, it is preferable to perform pumping down for more than ten minutes. The reason why the pumping down should be performed for more than ten minutes is shown in FIG. 4. As noted from the result of FIG. 4, the pressure of the cassette chamber 200 decreases in proportion to the pumping down time. Therefore, the pressure of the cassette chamber 200 decreases as the pumping down time increases.

Continuously, the wafer transfer chamber 210 transfers the wafer 204 from the cassette chamber to the reaction chamber 220 by the robot arm 212. The polysilicon film is completed by injecting the gas selected from the group consisting of silane, disilane, and the gas mixture in which silane and disilane are mixed in the 30:1 to 1:30 ratio to the reaction chamber as source gas for forming the polysilicon film and forming HSG-Si by performing a thermal treatment thereon. The polysilicon film is preferably used as a lower electrode of the capacitor.

In the first embodiment, the pressure of the cassette chamber 200 is controlled to be less than 0.05mtorr. Therefore, the influx of the contaminant gas of the atmosphere into the wafer transfer chamber 210 is prevented and the moisture supplied by the wet preprocessing for removing native oxide film or organic material and existing on the surface of the wafer can be completely evaporized from the surface of the wafer. Therefore, the problem that the remaining moisture on the surface of the wafer is evaporized in the wafer transfer chamber or the reaction chamber and acts as contaminant particles is solved since the influx of the contaminant gas into the wafer transfer chamber 210 or the reaction chamber 220 is prevented.

### <The Second Embodiment>

The second embodiment of the polysilicon film fabricating method according to the present invention is different from the first embodiment in that the pressure of the cassette chamber 200 is not controlled but the pressure of the wafer cooling chamber 230 is controlled to be equal to that of the wafer transfer chamber 210.

In particular, the wafer whose reaction is completed is cooled in the cooling chamber 230 by controlling the pressure of the wafer cooling chamber 230 to be equal to that of the wafer transfer chamber 210 without using the cooling gas in the second embodiment. Especially, the pressure of the wafer cooling chamber 230 and the wafer transfer chamber 210 is preferably kept less than 1µtorr. If the wafer is cooled in the wafer cooling chamber 230 without using the cooling gas during the step of cooling the wafer, it is prevented that the pressure of the wafer transfer chamber and the reaction chamber increases by the injecting pressure of the cooling gas. Therefore, the phenomenon that increased pressure of the reaction chamber results in contamination of the surface of the wafer during the step of heating the wafer may be prevented.

### <The Third Embodiment>

In the third embodiment of the present invention, the polysilicon film is fabricated using the reaction chamber shown in FIG. 3.

First, the wafer for forming the polysilicon film is loaded in the cassette chamber 200. Continuously, the robot arm 212 places the wafer on the susceptor 394 in the reaction chamber 220 through the wafer transfer chamber 210. Then, the temperature of the reaction chamber 220 is raised to a certain temperature by the heater 390 in the heating block 392.

Then, the amorphous silicon film is formed to a predetermined thickness on the wafer using the gas selected from the group consisting of silane, disilane, and the gas mixture in which silane and disilane are mixed in the 30:1 to 1:30 ratio as the source gas. The polysilicon film is completed by forming the HSG-Si by performing the thermal treatment on the wafer on which the amorphous silicon film is formed. The polysilicon film is preferably used as a lower electrode of the capacitor.

When the processing proceeds in the reaction chamber, the problem that gas is exuded from the walls of the cooling chamber is prevented by supplying the refrigerant to the first to fifth cooling jackets 400, 410, 420, 430, and 440. Therefore, according to the third embodiment, it is possible to form the polysilicon film whose area is enlarged to the utmost.

The characteristic of the present invention is described in detail with reference to the following examples.

### <Example 1>

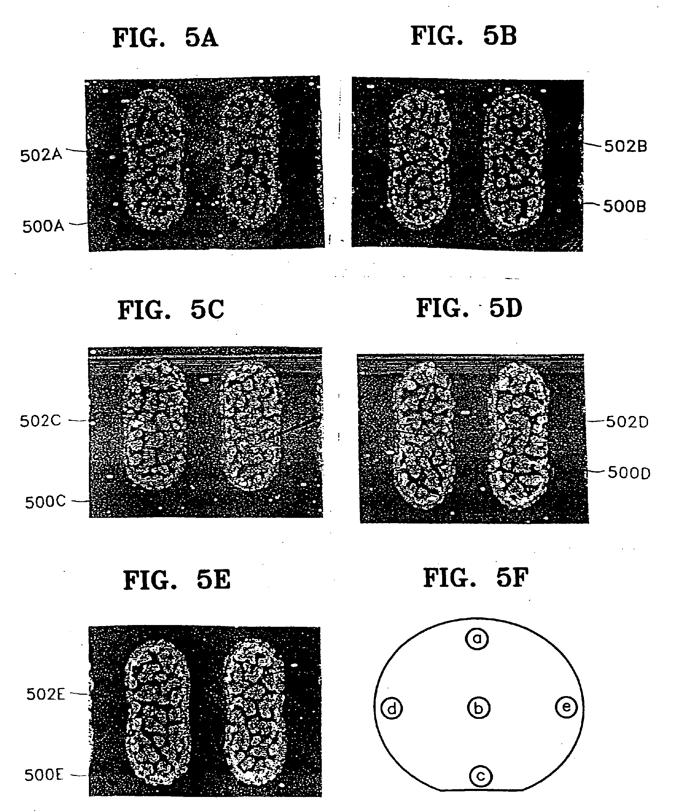

A wafer on which an insulating layer with a contact hole exposing a source region have been already formed is loaded on a susceptor 394 in the semiconductor device fabricating apparatus according to the present invention shown in FIG. 3. The capacitor having enlarged surface area is fabricated by forming an amorphous silicon layer to the thickness of 3000Å by flowing the disilane gas and then, forming the HSG-Si by flowing the disilane gas with a flow rate of 18sccm, on the surface of the amorphous silicon layer controlling the temperature of wafer to 620°C. During the above processing, the temperature of the walls of the wafer cooling chamber is kept to be 10°C by flowing the refrigerant of 9°C into the first to the fifth cooling jackets 400, 410, 420, 430 and 440. The photographs of the lower electrode of the capacitor formed in the above way taken with the scanning electron microscope are shown in FIG. 5. FIGS. 5A to 5E show the photographs of the surface of the lower electrode of the capacitor formed in the positions of the wafer shown in FIG. 5F. Reference numerals 500A, 500B, 500C, 500D, and 500E respectively denote the insulating layers. Reference numerals 502A, 502B, 502C, 502D, and 502E respectively denote the surfaces of the lower electrodes on which the HSG-Si is formed. As noted from the above photographs, the surface area is maximized regardless of the position of the wafer on which the lower electrode is formed since HSG-Si is uniformly formed on the surface of the lower electrode.

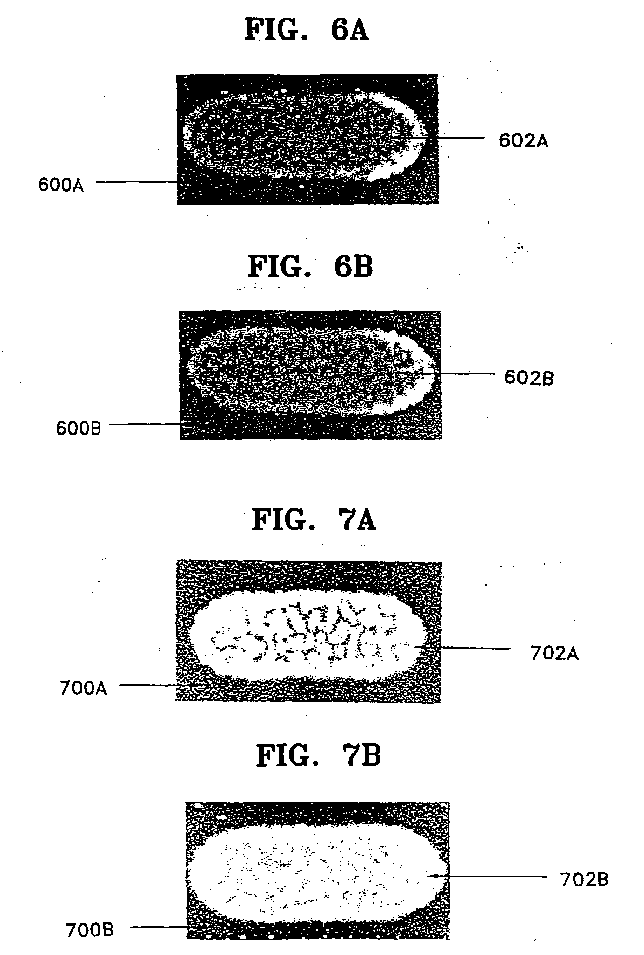

To clearly check the prevention effect of the gas exudation of the semiconductor device fabricating apparatus according to the present invention, the lower electrode of the capacitor is also formed in the conventional semiconductor device fabricating apparatus shown in FIG. 1 after controlling the processing condition such as reaction gas and temperature to be equal to that of the present invention, as a contrast group. The scanning electron microscope photographs of the lower electrodes of a contrast group are shown in FIGS. 6A and 6B. FIGS. 6A and 6B respectively show the lower electrode formed in the reaction chamber which is adjacent to the wafer transfer chamber and the lower electrode formed in the reaction chamber which is adjacent to a vent portion. The reference numerals 600A and 600B respectively denote the insulating films. The reference numerals 602A and 602B respectively denote the surfaces of the lower electrodes on which the HSG-Si is formed. It is noted that there exist the portions in which the formation of the surface flection degrades.

When the lower electrode of the capacitor is formed using the semiconductor device fabricating apparatus according to the present invention, the temperature of the walls of the reaction chamber, especially, the gate valve 310, the first wall 300 to which the gate valve 310 is connected, and the second wall 320 on which the vent portion is formed can be kept low. Therefore, the problem that the formation of the surface flection degrades as the speed of the surface movement decreases due to the exuded gas is overcome since the gas exudation from the chamber walls is prevented.

### <Example 2>

To examine the relations between the pressure of the cassette chamber and the pressure of the wafer transfer chamber and between the pressure of the cassette chamber and the pressure of the reaction chamber, the pressure between the respective chambers are measured.

**<Table 1>**

| | a cassette chamber | a wafer transfer chamber | | a reaction chamber | |
|---|---|---|---|---|---|
| | | initial pressure | changed pressure | initial pressure | changed pressure |
| a contrast group | 0.1mtorr | 0.23µtorr | 2.2µtorr | 7.3ntorr | 20ntorr |
| an experimental group | 0.02mtorr | 0.23µtorr | 0.23µtorr | 7.3ntorr | 13ntorr |

As noted from the results of the experimental group, in the case of controlling the pressure of the cassette chamber to be 0.02mtorr, even though the gate valves between the cassette chamber and the wafer transfer chamber and between the cassette chamber and the reaction chamber are opened, the pressure in the respective chambers does not increase.

The lower electrode with the HSG-Si is also formed by depositing the amorphous silicon film by controlling the pressure of the cassette chamber to be 0.05mtorr and flowing the disilane at a flow rate of 18sccm as a source gas and controlling the temperature of the wafer to be 620°C. The photograph of the surface of the lower electrode with the scanning electron microscope is shown in FIG. 7A. The scanning electron microscope photograph of the lower electrode formed by controlling the pressure of the cassette chamber to be 0.1mtorr and controlling the other conditions to be equal to those of the example of the present invention as a comparing group for comparing with the result of the example is shown in FIG. 7B. The reference numerals 700A and 700B respectively denote the insulating layers. The reference numerals 702A and 702B respectively denote the surfaces of the lower electrodes.

As noted from FIG. 7A, while it is possible to form a uniform HSG-Si on the surface of the lower electrode in the case of controlling the pressure of the cassette chamber to be 0.05mtorr according to the present invention, the degradation of the surface flection is generated as shown from FIG. 7B by the contaminant of the atmosphere and the evaporized vapor from the wafer in the case of controlling the pressure of the cassette chamber to be high as in the conventional technology.

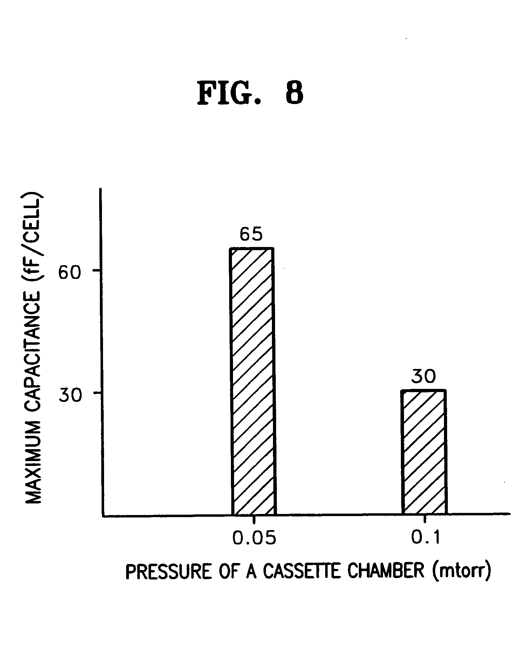

FIG. 8 is a bar graph showing the value of measuring the maximum capacitance of the capacitor shown in FIGS. 7A and 7B. This result shows the mean value of the maximum capacitance measured from 10 wafers. As noted from the graph, the capacitance of the capacitor formed by the present inventions is 65(fF/cell), which is twice that of the capacitor formed by the conventional technology, i.e., 30(fF/cell).

### <Example 3>

To examine the relations between the pressure of the cooling chamber and the pressure of the wafer transfer chamber and between the pressure of the cooling chamber and the pressure of the reaction chamber, the pressure between the respective chambers are measured.

**<Table 2>**

| | a wafer cooling chamber | a wafer transfer chamber | | reaction chamber | |
|---|---|---|---|---|---|
| | | initial pressure | changed pressure | initial pressure | changed pressure |
| a contrast group | 240 mtorr | 0.25µtorr | 2.3µtorr | 7.3ntorr | 2.3µtorr |
| an experimental group | 1µtorr | 0.25µtorr | 0.25µtorr | 7.3ntorr | 15ntorr |

As noted from the results of the contrast group, in the case of cooling the wafer in the wafer cooling chamber, the cooling gas raises the pressure of the wafer transfer chamber (0.25µtorr→2.3µtorr) and, in the case of transferring the wafer to the reaction chamber to perform another processing to the wafer in the above state, the cooling gas also raises the pressure of the reaction chamber (7.3ntorr→2.3µtorr). Such an increase of the pressure causes to contaminate the surface of the wafer in the case of raising the temperature of the transferred wafer. Therefore, in the case of cooling the wafer in the wafer cooling chamber under the pressure which is equal to that of the wafer transfer chamber, i.e., 1µtorr without using the cooling gas like in the experimental group, there is little change of the pressure in the wafer transfer chamber and the reaction chamber, thus suppressing the contamination of the reaction chamber.

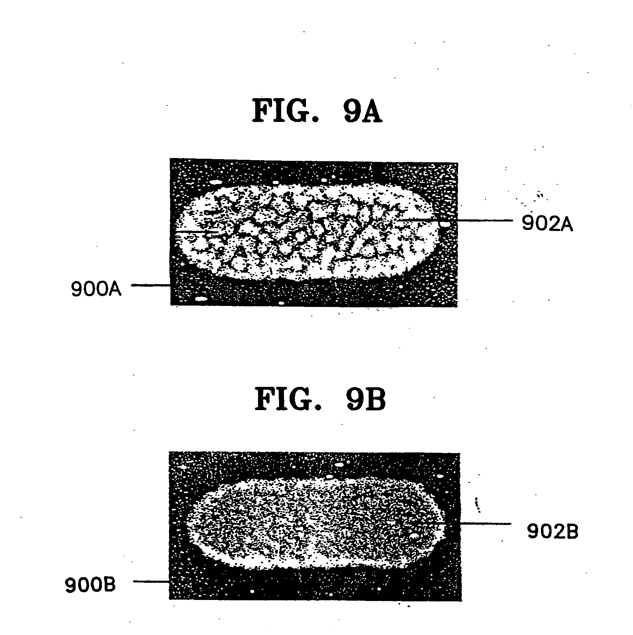

The scanning electron microscope photograph of the surface of the lower electrode in which the HSG-Si is formed by depositing the amorphous silicon film by controlling the pressure of the wafer cooling chamber and the wafer transfer chamber to be 1µtorr and flowing the disilane at a flow rate of 18sccm as a source gas and controlling the temperature of the wafer to be 620°C is shown in FIG. 8A. The scanning electron microscope photograph of the lower electrode formed by injecting argon of the pressure of 240mtorr as the cooling gas and controlling the other conditions to be equal to those of the example of the present invention as a comparing group is shown in FIG. 9B. The reference numerals 900A and 900B denote the insulating layers. The reference numerals 902A and 902B denote the surface of the lower electrode.

It is noted from the result of FIG. 9A that a flection is uniformly formed on the surface of the amorphous silicon when the pressure of the wafer cooling chamber and the wafer transfer chamber are equally kept under 1µtorr. It is also noted from the result of FIG. 9B that it is impossible to obtain a desirable surface flection effect due to the reduction of the speed of the surface migration of the amorphous silicon atoms to the crystalline silicon when the wafer is cooled in the wafer cooling chamber using the cooling gas and the pressure of the wafer cooling chamber is higher than 1µtorr.

### <Example 4>

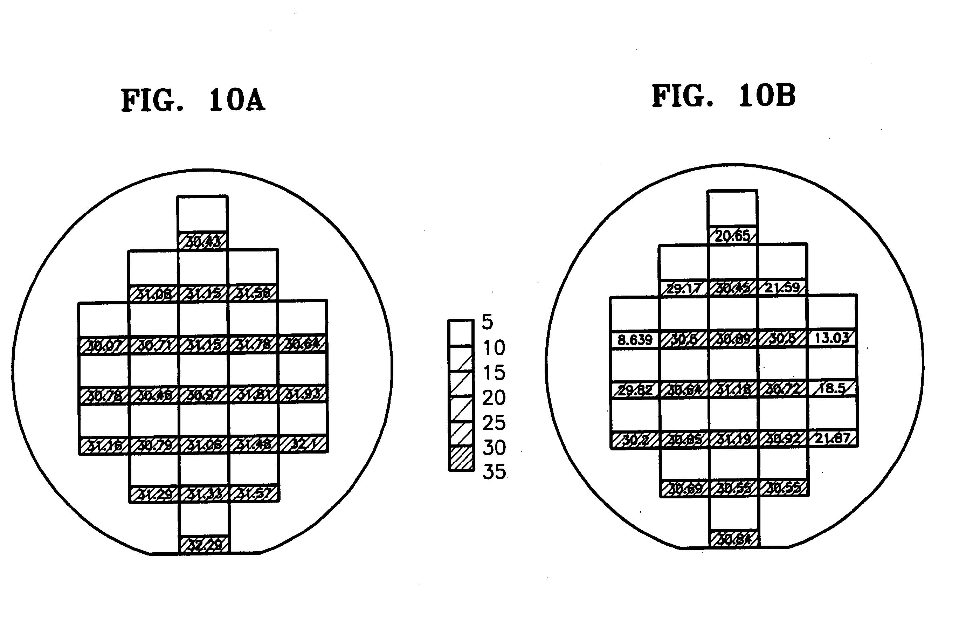

The result of measuring the capacitances of the respective portions of the wafer after forming the lower electrode of the capacitor by controlling the pressure of the cassette chamber to be 0.05mtorr and that of the wafer cooling chamber and the wafer transfer chamber to be less than 1µtorr and controlling the other conditions to be equal to those of the example 1 is shown in FIG. 10A. The capacitances of the respective portions of the wafer after forming the lower electrode of the capacitor by a conventional processing condition using the conventional apparatus is shown in FIG. 10B. The numbers in the respective blocks denote the capacitances. It is noted from FIGS. 10A and 10B that the lower electrodes have a uniform capacitance through the whole surface of the wafer when the lower electrode of the capacitor is formed by the present invention.

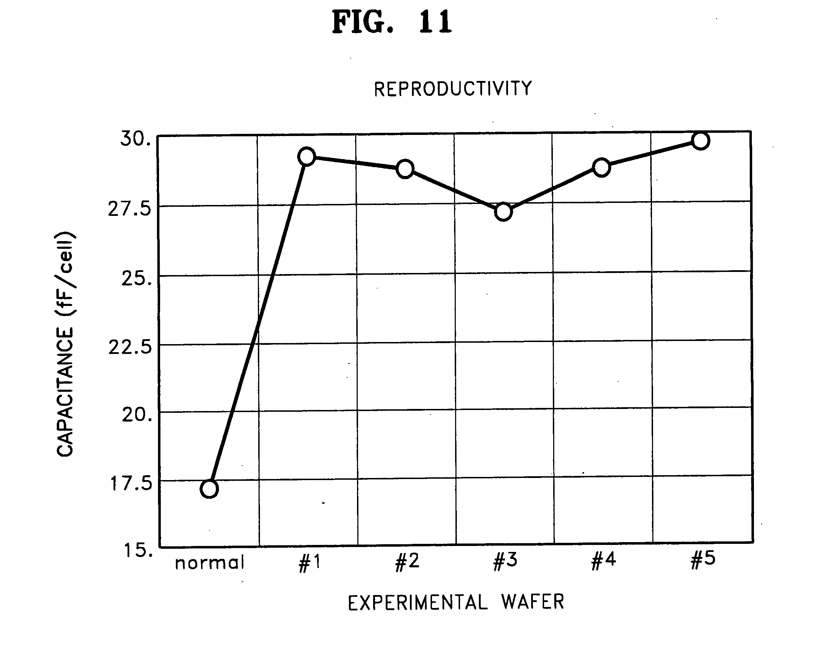

FIG. 11 is a graph showing the capacitance measured after continuously performing the processings on the five wafers according to the fourth example. When the polycrystalline silicon film is formed using the semiconductor device fabricating apparatus according to the present invention, it is possible to obtain the result that the capacitance is uniform, namely, the reproduction is high compared with the conventional apparatus and method even though the processings continuously proceed.

In particular, when the reaction chamber includes the cooling jacket like the apparatus of the present invention, the reliability to the processing performance is improved since it is possible to prevent gas from being exuded in the reaction chamber. Also, when the polycrystalline silicon film is formed using the semiconductor device fabricating apparatus according to the present invention, it is possible to prevent the reduction of the speed of the surface migration of the amorphous silicon due to the contaminants. Therefore, it is possible to repeatedly form a capacitor having high capacitance.

## Claims

1. A method for fabricating a polysilicon film comprising the steps of:
loading a wafer in a cassette chamber;
transferring the loaded wafer to a reaction chamber through a wafer transfer chamber;
forming an amorphous silicon film on the wafer by injecting gas selected from the group consisting of silane, disilane, and the gas mixture in which silane:disilane ratio is 30:1 to 1:30 to the reaction chamber;
transforming the amorphous silicon film into a polysilicon film on which HSG-Si is formed by thermally treating the wafer having the amorphous silicon film; and
transferring the wafer on which the HSG-Si is formed to the cooling chamber and cooling it,
wherein the pressure of the cassette chamber is adjusted to be less than 0.05mtorr.

2. The method of claim 1, wherein the pressure of the cassette chamber is adjusted by pumping down for ten to thirty minutes.

3. A method for fabricating a polysilicon film comprising the steps of:
loading a wafer in a cassette chamber;
transferring the loaded wafer to a reaction chamber through a wafer transfer chamber;
forming an amorphous silicon film on the wafer by injecting gas selected from the group consisting of silane, disilane, and the gas mixture in which silane:disilane ratio is 30:1 to 1:30 to the reaction chamber;
transforming the amorphous silicon film into a polysilicon film on which HSG-Si is formed by thermally treating the wafer having the amorphous silicon film; and
transferring the wafer on which the HSG-Si is formed to the cooling chamber and cooling it,
wherein the pressure of the cooling chamber and transferring chamber is adjusted to be equal.

4. The method of claim 3, the pressure of the cooling chamber and wafer transfer chamber is formed to be less than 1.0µtorr.

5. The method of any of claims 2 to 4, wherein the polysilicon film is a lower electrode of a capacitor.
